# EUROPEAN PATENT APPLICATION

(11) **EP 4 589 647 A1**
(43) Date of publication of application: **23.07.2025**
(21) Application number: 24213010.2
(22) Date of filing: 14.11.2024
(51) Int. Cl.: H01L 21/687

(54) **AN END EFFECTOR FOR CARRYING A WAFER OR A WAFER ASSEMBLY**

(30) Priority: 16.01.2024 GB 202400569
(71) Applicant: SPTS Technologies Limited, NP18 2TA (GB)
(72) Inventor: FORD, Mark, Newport (GB); WALLER, Phil, Newport (GB); NAGY, Attila, Newport (GB)
(74) Representative: Wynne-Jones IP Limited

(57) **Abstract**

There is provided an end effector for carrying a wafer or a wafer assembly placed thereon. The end effector is integrated with, or configured to attach to, a robotic arm. The end effector comprises a peripheral mount radially outside of a base portion, the peripheral mount comprising at least a first mount section and a second mount section for example arranged on opposing sides of the base portion. The base portion has a substantially flat horizontal upper surface. Furthermore, each mount section of the peripheral mount has a substantially flat horizontal upper surface being elevated with respect to the upper surface of the base portion. The end effector is thereby configured to hold a wafer assembly bridging the upper surfaces of the mount sections at a first height above the base portion. There is a step region between the base portion and the peripheral mount at each mount section. Each step region comprises a support surface being elevated with respect to the upper surface of the base portion. The end effector is thereby configured to hold a wafer bridging the support surfaces at a second height above the base portion.

## Description

### Field

The invention relates generally to end effectors for transporting individual wafers and wafer assemblies before, after or during processing. The invention also relates to semiconductor processing devices incorporating such end effectors, and methods of transporting wafers and wafer assemblies.

### Background

Wafers to be processed are typically transported by robotic arms with end effectors which support and carry the wafers. In plasma dicing applications, the wafer to be diced tends to be attached to a carrier which is suitable for retaining the individual semiconductor dies after separation. Such wafer assemblies include wafers supported on film/ tape in a frame, and wafers mounted on silicon or glass substrates.

The handling and transportation of the wafer assemblies tends to be via dedicated robotic arms with suitably configured end effectors which operate with a particular wafer carrier type, size and shape. In arrangements in which the wafer is supported on a film/ tape and frame, the end effectors tend to make contact with the frame or the tape and the frame, but avoid contact with the tape under the wafer, so that the dies are not inadvertently displaced after dicing. An advantage of using dedicated robotic arms is the avoidance of cross contamination between different wafer assemblies.

US9343365B2 describes a method and apparatus for plasma dicing a semiconductor wafer in which a wafer supported on a tape and frame is transferred into and out of a process chamber by a transfer arm. The transfer arm has a central recess so that it contacts the frame whilst avoiding contact with the tape directly underneath the substrate wafer.

US9446522B2 describes an arrangement wherein a wafer carrier ring is supported by prongs of an end effector which make contact with the ring but avoid contacting the wafer substrate on the carrier.

There is a desire in the art for a multi-purpose end effector which can operate with different wafers and wafer assembly types without requiring reconfiguration or replacement, whilst protecting the wafers from contamination. Such a multifunctional end effector would have particular utility in vacuum transportation applications where it can be more difficult and/or expensive to reconfigure the tooling.

### Summary

In a first aspect of the invention there is provided an end effector for carrying a wafer or a wafer assembly placed thereon, the end effector being integrated with, or configured to attach to, a robotic arm. The end effector comprises a peripheral mount arranged circumferentially around a base portion, the peripheral mount comprising at least a first mount section and a second mount section. The base portion has a substantially flat horizontal upper surface, and each mount section of the peripheral mount has a substantially flat horizontal upper surface being elevated with respect to the upper surface of the base portion, the end effector thereby being configured to hold a wafer assembly bridging the upper surfaces of the mount sections at a first height above the base portion. There is a step region between the base portion and the peripheral mount at each mount section. Each step region comprises a support surface being elevated with respect to the upper surface of the base portion, the end effector thereby being configured to hold a wafer bridging the support surfaces at a second height above the base portion.

The present invention thereby provides an end effector which can carry both a wafer and a wafer assembly (although not necessarily concurrently). The present invention thus provides a dual function end effector which avoids the need for replacement of tooling during wafer bonding, etching, and other processing. The end effector of the present invention enables quick switching between wafer carrying, and wafer assembly carrying applications, offering versatility over end effectors of the prior art and saving time and costs in semiconductor production.

Furthermore, end effectors according to the present invention prevent metal cross-contamination between wafer and wafer assemblies carried on the device, since the wafer and wafer assemblies are supported on different horizontal planes. Moreover, the end effector of the present invention minimises disturbance to the wafer substrate by providing a vertical separation between the base portion and the wafer or wafer assembly placed on the device.

In the context of the present invention a "wafer" will be taken to include a wafer mounted on a support wafer, for example a silicon wafer mounted on a glass wafer. The wafer may also be unmounted. The support wafer may typically have the same or similar dimensions to the wafer, for example having a diameter of 200mm or 300mm. The wafer may preferably be a circular wafer.

In the context of the present invention a "wafer assembly" will be taken to include a wafer mounted on a film/ tape supported in a frame. The wafer assembly may preferably be a substantially circular wafer assembly for example wherein a circular wafer is supported on a substantially circular frame.

The base portion may be substantially circular in shape, or comprise part of a circle for example with truncated sides. The upper surface of the base portion may comprise a continuous flat surface or there may be one or more cut out regions of the base portion. The mount sections may be arranged on opposing sides of the base portion, for example the mount sections may be diametrically opposed across the upper surface of the base portion. Alternatively, the mount sections may be non-diametrically opposed, for example being positioned at 90 degrees from one other, around a notional centre point of the base portion. In this context "on opposing sides" will be understood to mean at different circumferential locations around the perimeter of the base portion.

There may be more than two, for example three or more mount sections. The mount sections may be comprised in one contiguous body, or may be discrete mount sections.

The mount sections and corresponding step regions may be symmetric across the base portion.

The end effector may comprise two spaced apart prongs extending from a connector body, wherein the connector body is configured to attach to the robotic arm.

The connector body may comprise a toothed edge (i.e. comprising a plurality of notches in an end face) for connection with a robotic arm having a connection face with a complementary shape. The connector body may alternatively comprise a different type of connector for attaching to the robotic arm.

The connector body may comprise a mount section, and each prong may comprise a further mount section (along with a respective part of the base portion). Each further mount section may be at a distal end from the connector body.

The prongs may narrow towards a distal end from the connector body.

A boundary line between the step region and the base portion may be defined by a circumferential arc. In an arrangement wherein the end effector is configured (i.e. suitably sized and shaped) to carry a 300mm wafer or a 300mm wafer assembly, the radius of the circumferential arc may be 146-150mm taken from a notional centre point of the base portion.

A boundary line between the step region and the peripheral mount may be defined by a circumferential arc. In an arrangement wherein the end effector is configured (i.e. suitably sized and shaped) to carry a 300mm wafer or a 300mm wafer assembly, the radius of the circumferential arc may be 150-154mm from a notional centre point of the base portion.

The upper surface of the peripheral mount may extend a length of at least 15mm, for example 20mm, in a direction parallel a central longitudinal axis of the end effector, beyond a boundary line between the step region and the peripheral mount. A length of at least 15mm may enable a variety of wafer assembly types and sizes (for example non-standard frame sizes) to be supported and transported.

The first height may be 1-5mm. The second height may be 0.1-3mm. The first height may be greater than the second height.

The support surface may comprise a ledge.

A length of the ledge in a direction parallel a central longitudinal axis of the end effector may be 0.2-0.6mm, for example 0.4mm.

A length of at least 0.2mm may be sufficient to support the wafer edge whilst minimising the overall dimensions of the end effector.

The support surface may comprise a convex surface. A convex surface may enable a tape of a wafer assembly supported on the end effector to rest on a smooth surface wherein there is no sharp edge or corner beneath the tape.

The ledge may be adjacent the base portion and the convex surface may adjoin the ledge and the peripheral mount.

The convex surface may be defined by an arc of radius 2.5-3.5mm.

The base portion may have a depth of 3mm in a direction normal to its upper surface.

The end effector may be formed from a ceramic material. The end effector may be formed from a metal.

The end effector may be formed from a metal coated with an electrostatic discharge material.

In a second aspect there is provided a semiconductor processing device comprising a robotic arm and an end effector. The end effector is integrated with, or attached to, the robotic arm. The end effector comprises a peripheral mount radially outside of a base portion, the peripheral mount comprising at least a first mount section and a second mount section. The base portion has a substantially flat horizontal upper surface, and each mount section of the peripheral mount has a substantially flat horizontal upper surface being elevated with respect to the upper surface of the base portion. The end effector is thereby configured to hold a wafer assembly bridging the upper surfaces of the mount sections at a first height above the base portion. There is a step region between the base portion and the peripheral mount at each mount section. Each step region comprises a support surface being elevated with respect to the upper surface of the base portion. The end effector is thereby configured to hold a wafer bridging the support surfaces at a second height above the base portion.

In a third aspect there is provided a method of transporting a wafer using a semiconductor processing device comprising a robotic arm and an end effector according to the first aspect of the invention. The end effector is integrated with, or attached to, the robotic arm. The method comprises the steps of: placing the wafer onto the end effector such that the wafer bridges the support surfaces of each step region; and transporting the wafer by moving the robotic arm.

In a fourth aspect there is provided a method of transporting a wafer assembly using a semiconductor processing device comprising a robotic arm and an end effector according to the first aspect of the invention. The end effector is integrated with, or attached to, the robotic arm. The method comprises the steps of: placing the wafer assembly onto the end effector such that the wafer assembly bridges the upper surfaces of each mount section; and transporting the wafer assembly by moving the robotic arm.

### Drawings

An embodiment of the present invention will now be described by way of example only with reference to the accompanying schematic drawings:
Figure 1 is a perspective view of a wafer according to the example embodiment of the invention;
Figure 2 is a perspective view of a wafer assembly according to the example embodiment of the invention;
Figure 3 is a perspective view of an end effector according to the example embodiment of the invention;
Figure 4 is a top view of the end effector of the example embodiment of the invention;
Figure 5 is a side view of the end effector of the example embodiment of the invention;
Figure 6 is a side view of the end effector of the example embodiment of the invention supporting a wafer on a carrier; and
Figure 7 is a side view of the end effector of the example embodiment of the invention supporting a wafer on a film and frame.

### Detailed description

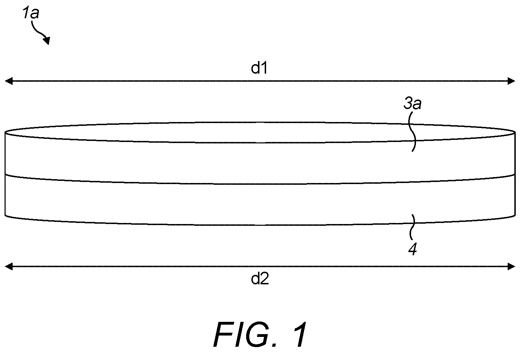

A wafer 1a (Figure 1) to be transported comprises a circular silicon wafer 3a on a circular glass substrate 4. The silicon wafer has a diameter d1 of 300mm. The glass substrate 4 has a corresponding diameter d2 of 300mm (but in an alternative embodiment could have a larger diameter than the wafer 3a). In an alternative embodiment the wafer 3a may be unsupported, or may be supported on a different carrier such as a silicon substrate. Alternatively, in a different embodiment the wafer may have a different size for example the wafer may comprise a circular wafer of diameter 200mm.

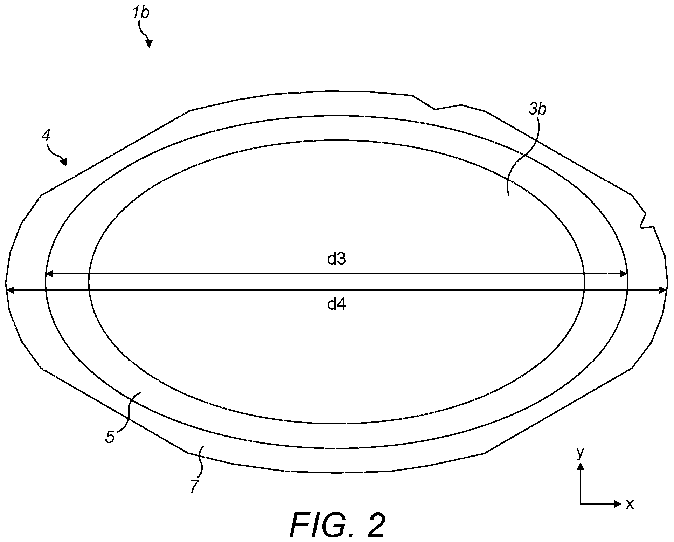

A wafer assembly 1b (Figure 2) to be transported comprises a 300mm circular silicon wafer 3b resting on a tape 5 supported in a frame 7 (i.e. tape and frame assembly 4). The wafer 3b, tape 5 and frame 7 are arranged concentrically, the frame 7 being mounted on the tape 5 and having a circular inner perimeter with a diameter d3 of 350mm. In the example embodiment, the outer perimeter of the frame 7 is circular with chamfered edges so that it comprises thicker edges in opposing lateral directions (x, y) across the assembly (i.e. the outer perimeter of the frame 7 is not precisely circular). The non-circular outer perimeter of the frame 7 has a maximum diameter d4 of 400mm. The wafer frame may for example meet a SEMI G87 or G74 300mm wafer frame specification. Alternatively, in a different embodiment the wafer assembly may be of a size and shape to hold a wafer of a different size. For example, in an embodiment in which the wafer is a 200mm circular silicon wafer, the wafer frame may have a circular inner perimeter with diameter of 250mm, and an outer perimeter with a maximum diameter of 300mm.

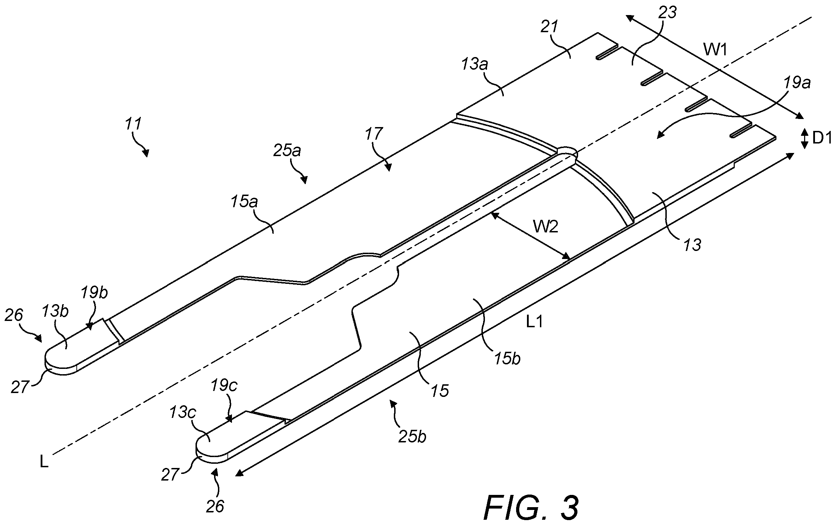

An end effector 11 (Figure 3) according to the example embodiment of the invention is configured to carry the wafer 1a and the wafer assembly 1b above-described interchangeably. The end effector 11 is of the example embodiment is formed from titanium covered with a non-electrostatic discharge coating and shaped so that the wafer 1a and wafer assembly 1b are supported on different horizontal planes to make contact with different parts of the end effector 11. In the example embodiment, the non-electrostatic discharge coating comprises diamondlike carbon but in an alternative embodiment may comprise a different non-electrostatic discharge material. In another embodiment the end effector may be formed from aluminium or a different material.

The end effector 11 comprises a peripheral mount 13 arranged as three discrete mount sections 13a, 13b, 13c, around a recessed base portion 15. The base portion 15 is generally planar, having a flat upper surface 17 along a first horizontal plane. Each mount section 13a, 13b, 13c, of the peripheral mount has a flat upper surface 19a, 19b, 19c, along a second, elevated, horizontal plane.

The end effector 11 has a fork shape. The end effector 11 comprises a connector body 21 integral with, and extending outwardly along a central longitudinal axis L from, a first mount section 13a of the peripheral mount. The connector body 21 comprises a toothed end section 23 shaped to interconnect with a complementary shaped connector of a robotic arm (not shown).

The end effector 11 comprises two prongs 25a, 25b extending from the first mount section 13a in a direction parallel the central longitudinal axis L. The end effector 11 is symmetric about the central longitudinal axis L. Each prong 25a, 25b comprises a respective part 15a, 15b of the base portion 15. Each prong 25a, 25b comprises at a distal end 26 from the connector body 21 a mount section 13b, 13c. The second and third mount sections 13b, 13c comprise a rounded end face 27.

Overall, in the example embodiment which transports a 300mm wafer and a 300mm wafer assembly, the end effector 11 has a length L1 of 410-450mm, a width W1 of 100-175mm and a depth D1 of 6mm. The width W1 of the end effector is constant along its length. The prongs 25a, 25b each have a width W2 which decreases with distance from the connector body 21 towards the distal ends 26. In other words the lateral separation between the prongs increases towards the distal ends. In other embodiments of the invention, the dimensions of the end effector can be scaled suitably to transport a wafer/ wafer assembly of a different size for example a 200mm wafer/ wafer assembly.

The depth of the end effector 11 varies along its length. The horizontal plane of the upper surface 17 of the base portion 15 is recessed with respect to the horizontal plane of the upper surfaces of the peripheral mount 13. More specifically, the horizontal plane of the upper surface 17 of the base portion 15 is recessed with respect to the horizontal plane of the upper surfaces 19a, 19b, 19c of the mount sections 13a, 13b, 13c of the peripheral mount 13.

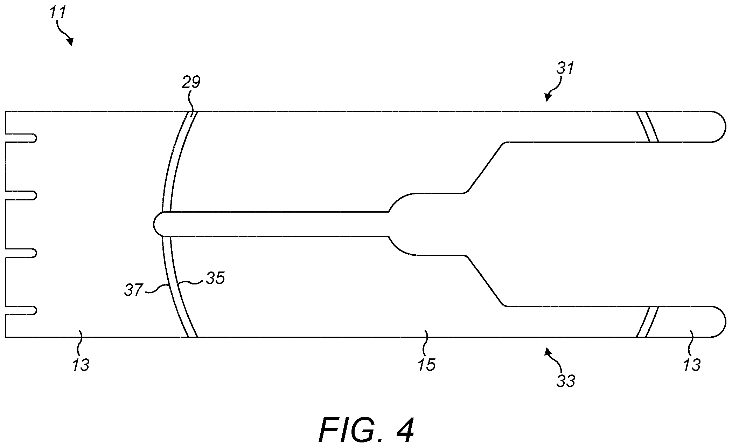

The end effector 11 comprises a step region 29 (Figure 4) between the base portion 15 and the peripheral mount 13. The perimeter of the base portion 15 as comprised by each of the two prongs 25a, 25b, in a top view is defined by a circle of radius 152mm (from a notional centre point of the base portion 15). The circle is truncated on each of an upper side 31 and a lower side 33 of the end effector, so that the base portion 15 is defined by a mid-portion of the circle. In other words, the imprint of the base portion 15 fits within a notional circle of radius 152mm. The step region 29 comprises a ring of breadth 4mm, bounded on an inner circumferential edge 35 by the base portion 15 and bounded on an outer circumferential edge 37 by the peripheral mount 13.

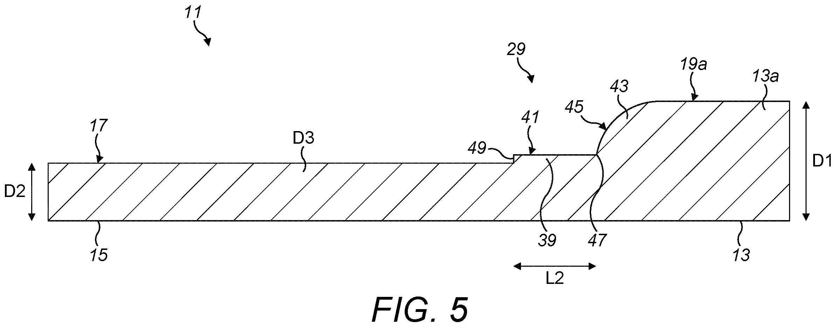

In a cross-sectional side view (Figure 5) the step region 29 comprises an inner square step 39 having a flat upper surface 41 (i.e. a horizontal ledge) and an outer rounded step 43 having a top surface 45 defined by an arc of radius 3mm. The base portion 15 has a constant depth D2 of 3mm. Each mount section 13a, 13b, 13c, has a constant depth D1 of 6mm. The connector body 21 (best shown in Figure 3) has a constant depth of 3mm extending beneath the horizontal plane of the upper surface 13a. The square step 39 (referring again to Figure 5) has a depth D3 of 3.4mm (i.e. the upper surface 41 of the square step 39 is a height of 0.4mm above the upper surface 17 of the base portion 15). The top surface 45 of the rounded step 43 forms a convex surface protruding outwards from the peripheral mount 13, meeting the square step 39 at an inner edge 47 and forming a plateau with the upper surface 19a of the first mount section 13a. The square step 39 has a length L2 between the inner edge 47 and a step edge 49 of 0.4mm. The step region 29 has the same profile at each of the mount sections 13a, 13b, 13c, facing inwards towards the base portion 15. The step regions associated with the second and third mount sections 13b, 13c, oppose the step region associated with the first mount section 13a, in a symmetric arrangement, so that the upper surfaces of each the square steps are on the same level horizontal plane. The upper surfaces 19a, 19b, 19c of each of the mount sections 13a, 13b, 13c are on the same level horizontal plane, being elevated with respect to the upper surfaces 41 of each the square steps 39.

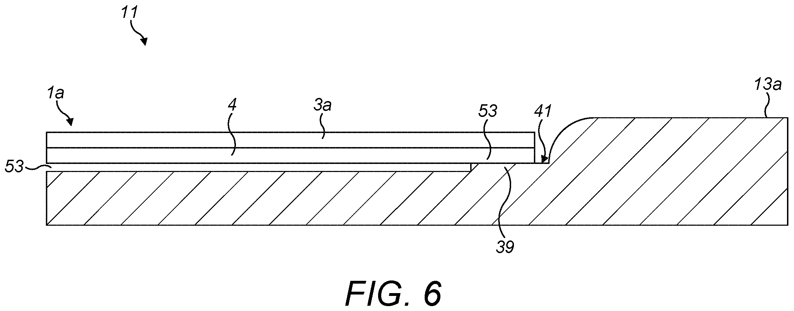

During use, the wafer 1a is supported on the end effector 11, to be transported (Figure 6). A first edge region 51 of the wafer 1a rests on the upper surface 41 of the square step 39 associated with the first mount section 13a. Second and third edge regions of the wafer 1a rest on upper surfaces of the square steps associated with the second and third mount sections (not shown in Fig. 6). Accordingly, the wafer 1a is supported on the end effector 11 in a horizontal plane at a height of 0.4mm above the upper surface 17 of the base portion 15. In other words, there is a gap 53 above the base portion 15 above which the wafer 1a is suspended. In the example embodiment of the invention, the square step 39 has a length L2 of 0.4mm which has been found to provide an optimal contact area to enable support of the wafer whilst holding the wafer at a distance above the upper surface 17 of the base portion 15.

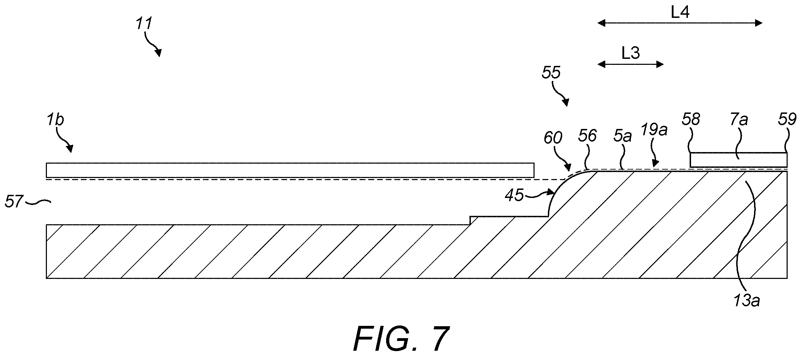

Alternatively, during use, the wafer assembly 1b is instead supported on the end effector 11, to be transported (Figure 7). A first edge region 55 of the wafer assembly 1b rests on the first mount section 13a. A second edge region of the wafer assembly 1b rests on the second mount section 13b (not shown in Fig. 7). A third edge region of the wafer assembly 1b rests on the third mount section 13c (not shown in Fig. 7). The frame 7 is thus supported on the end effector 11. The first edge region 55 of the wafer assembly 1a comprises a first section 7a of the frame 7 and a first bordering part 5a of the tape 5. The first section 7a of the frame 7 rests on the upper surface 19a of the first mount section 13a. The first bordering part 5a of the tape 5 rests partly on the upper surface 19a of the first mount section 13a and partly on the top surface 45 of the rounded step 43 of the step region 29. A similar arrangement is provided at the second and third mount sections 13b, 13c. The wafer assembly 1b is held securely in place on the end effector 11 by friction between the underside of the tape 5 and the top surface 45 of the rounded step 43 (at each mount section), and the upper surfaces 19a, 19b, 19c of the mount sections 13a, 13b, 13c.

An inner edge 58 of the first section 7a of the frame 7 resting on the upper surface 19a of the first mount section 13a is set back a length L3 of about 20mm from an outer edge 56 of the rounded step 43. An outer edge 59 of the first section 7a of the frame 7 is set back a length L4 of about 40mm from the outer edge 56 of the rounded step 43. Corresponding arrangements (i.e. mirror reflections) are provided at the second and third mount sections 13b, 13c. Advantageously, according to the present design, the mount sections 13a, 13b, 13c, have a size and a shape to accommodate a standard 300mm wafer frame, but also a non-standard 300mm wafer frame. The frame of a non-standard 300mm wafer assembly may still rest on the upper surfaces of the mount sections 13a, 13b, 13c, but the frame may be set back from the outer edge 56 of the rounded step 43 by a different amount i.e. the length L3 may vary, yet the tape and frame will still be adequately supported.

In an embodiment in which the wafer is a 200mm wafer and the wafer assembly is a 200mm wafer assembly, the dimensions of the step region and the mount sections may be comparable to in the example embodiment relating to the 300mm wafer, however, the radius of the circumferential line defining the inner boundary of the step region (taken from a notional centre point of the base portion) is reduced accordingly. The overall length and width of the end effector L1, W1 would be reduced. However, the length of the square step L2 would remain the same, as would the size of the rounded step 43 and the lengths of the upper surfaces 19a, 19b, 19c of the mount sections. The mount sections 13a, 13b, 13c, each have a length which is sufficient to accommodate non-standard wafer assemblies (whether for a 300mm wafer assembly or 200mm wafer assembly).

In the example embodiment, the tape 5 in each edge region 55 of the wafer assembly 1b follows the contour of the upper surface 19a of the first mount section 13a and a top portion 60 of the top surface 45 of the rounded step 43, before levelling into a horizontal plane. Accordingly, the tape 5 follows a smooth profile across each mount section 13a, 13b, 13c and the rounded steps 43 of the corresponding step regions, and there is no sharp edge or corner beneath the tape 5.

Each edge region of the wafer assembly 1b rests on the upper surfaces of the mount sections 13a, 13b, 13c, and on the corresponding step regions (not shown). Accordingly, the wafer 1b is supported on the end effector 11 in a horizontal plane at a height of 3mm above the upper surface 17 of the base portion 15. In other words, there is a gap 57 above the base portion 15 above which the wafer assembly 1b is suspended.

## Claims

1. An end effector for carrying a wafer or a wafer assembly placed thereon, the end effector being integrated with, or configured to attach to, a robotic arm;
the end effector comprising a peripheral mount arranged circumferentially around a base portion, the peripheral mount comprising at least a first mount section and a second mount section;
the base portion having a substantially flat horizontal upper surface, and each mount section of the peripheral mount having a substantially flat horizontal upper surface being elevated with respect to the upper surface of the base portion, the end effector thereby being configured to hold a wafer assembly bridging the upper surfaces of the mount sections at a first height above the base portion;
there being a step region between the base portion and the peripheral mount at each mount section;
each step region comprising a support surface being elevated with respect to the upper surface of the base portion, the end effector thereby being configured to hold a wafer bridging the support surfaces at a second height above the base portion.

2. An end effector according to claim 1, comprising two spaced apart prongs extending from a connector body, wherein the connector body is configured to attach to the robotic arm.

3. An end effector according to claim 2, wherein the connector body comprises a mount section, and each prong comprises a part of the base portion and a further mount section, the further mount section being at a distal end from the connector body.

4. An end effector according to claim 2 or 3, wherein the prongs narrow towards a distal end from the connector body.

5. An end effector according to any preceding claim, configured to carry a 300mm wafer or a 300mm wafer assembly, wherein a boundary line between the step region and the base portion is defined by a circumferential arc at a radius of 146-150mm from a notional centre point of the base portion.

6. An end effector according to any preceding claim, configured to carry a 300mm wafer or a 300mm wafer assembly, wherein a boundary line between the step region and the peripheral mount is defined by a circumferential arc at a radius of 150-154mm from a notional centre point of the base portion.

7. An end effector according to any preceding claim, wherein the upper surface of the peripheral mount extends a length of at least 20mm in a direction parallel a central longitudinal axis of the end effector, beyond a boundary line between the step region and the peripheral mount.

8. An end effector according to any preceding claim, wherein the first height is 1-5mm and wherein the second height is 0.1-3mm.

9. An end effector according to any preceding claim, wherein the first height is greater than the second height.

10. An end effector according to any preceding claim, wherein the support surface comprises a ledge and wherein a length of the ledge in a direction parallel a central longitudinal axis of the end effector is 0.2-0.6mm.

11. An end effector according to any preceding claim, wherein the support surface comprises a convex surface and wherein the convex surface is defined by an arc of radius 2.5-3.5mm.

12. An end effector according to any preceding claim, wherein the base portion has a depth of 3mm in a direction normal to its upper surface.

13. A semiconductor processing device comprising a robotic arm and an end effector;
the end effector being integrated with, or attached to, the robotic arm;
the end effector comprising a peripheral mount arranged radially outside of a base portion, the peripheral mount comprising at least a first mount section and a second mount section;
the base portion having a substantially flat horizontal upper surface, and each mount section of the peripheral mount having a substantially flat horizontal upper surface being elevated with respect to the upper surface of the base portion, the end effector thereby being configured to hold a wafer assembly bridging the upper surfaces of the mount sections at a first height above the base portion;
there being a step region between the base portion and the peripheral mount at each mount section;
each step region comprising a support surface being elevated with respect to the upper surface of the base portion, the end effector thereby being configured to hold a wafer bridging the support surfaces at a second height above the base portion.

14. A method of transporting a wafer using a semiconductor processing device comprising a robotic arm and an end effector according to any of claims 1-12, the end effector being integrated with, or attached to, the robotic arm, the method comprising the steps of:
placing the wafer onto the end effector such that the wafer bridges the support surfaces of each step region;
transporting the wafer by moving the robotic arm.

15. A method of transporting a wafer assembly using a semiconductor processing device comprising a robotic arm and an end effector according to any of claims 1-12, the end effector being integrated with, or attached to, the robotic arm, the method comprising the steps of:
placing the wafer assembly onto the end effector such that the wafer assembly bridges the upper surfaces of each mount section;
transporting the wafer assembly by moving the robotic arm.
